# EUROPÄISCHE PATENTSCHRIFT

(11) **EP 0 406 469 B1**
(45) Veröffentlichungstag und Bekanntmachung des Hinweises auf die Patenterteilung: **27.09.1995**
(21) Anmeldenummer: 89112332.5
(22) Anmeldetag: 06.07.1989
(51) Int. Cl.: H03L 7/18

(54) **Digitale Steuerschaltung für Abstimmsysteme**
Digital control circuit for tuning systems
Circuit de commande numérique pour des systèmes d'accord

(43) Veröffentlichungstag der Anmeldung: 09.01.1991
(73) Patentinhaber: Deutsche ITT Industries GmbH, 79108 Freiburg (DE)
(72) Erfinder: Micic, Ljubomir, Dipl.-Ing., D-7800 Freiburg (DE); Mlynek, Daniel, Dr.-Ing., CH-1603 Grand Vaux (CH); Sieben, Ulrich, Dr.Dipl-Phys., D-7801 Reute (DE); Heberle, Klaus, Dipl.-Ing. (FH), D-7801 Reute (DE)

(56) Entgegenhaltungen:
- WO-A-87/07794
- WO-A-88/01113
- DE-B- 2 636 150
- GB-A- 2 144 005
- US-A- 4 410 860
- US-A- 4 810 974

## Beschreibung

Geräte zum Empfang hochfrequenter Signale enthalten Steuereinrichtungen, mit denen ein zur Frequenzumsetzung erforderlicher lokaler Oszillator auf die richtige Schwingungsfrequenz gesetzt wird. Hierzu wird in der Regel die spannungsabhängige Kapazität von Tunerdioden ausgenutzt, um die Eigenfrequenz von Hochfrequenz-Oszillatoren in weiten Bereichen zu variieren. Meist sind dabei gleichzeitig mehrere Tunerdioden im Einsatz, deren Steuerkennlinien gepaart sind, um einen Kapazitätsgleichlauf bei unterschiedlichen Tuner-Abstimmspannungen zu gewährleisten.

Die manuelle Einstellung der Tuner-Abstimmspannung wird bei modernen Geräten vorteilhafterweise immer mehr durch digitale Steuerschaltungen ersetzt, wobei die Langzeitkonstanz und die Genauigkeit in der Einstellung und Reproduzierbarkeit erheblich gesteigert ist. Es wird dabei zwischen Spannungs- und Frequenzsyntheseverfahren unterschieden, wobei letztere eine Phasenregelschleife (= PLL) enthalten, welche die definierte Einstellung beliebiger lokaler Oszillatorfrequenzen erlaubt.

In der "ITT Semiconductors" Firmendruckschrift, "SAA 1290, Remote-Control and Tuning IC for TV Receivers", Ausgabe 1986, Juli, Bestellnummer 6251-222-5E ist beispielsweise eine monolithisch integrierte, digitale Steuerschaltung für Abstimmsysteme von Fernsehempfängern beschrieben, die eine Einrichtung zur Erzeugung einer Tuner-Abstimmspannung nach dem Spannungssyntheseverfahren aufweist. Als Ausgangssignal wird eine pulsdichtemodulierte Impulsfolge (= PDM-Signal) abgegeben, die über externe Schalteinrichtungen ein PDM-Signal mit einer Amplitude von 33 V erzeugt. Dieses Signal wird mittels eines mehrgliedrigen Tiefpasses geglättet, um die zeitlich konstante Tuner-Abstimmspannung zu ergeben. Es handelt sich hier bei dieser beschriebenen Einrichtung zur Erzeugung der Tuner-Abstimmspannung demnach um einen dynamischen Digital-Analogumsetzer, der aus den abgelegten Daten mittels eines Pulsdichtemodulators das gewünschte Analogsignal hoher Auflösung bildet.

Die beschriebene Steuerschaltung enthält ferner vier weitere dynamische Digital-Analogumsetzer, die aus gespeicherten Daten analoge Funktions-Einstellspannungen geringer Auflösung erzeugen, z.B. für die Lautstärke- oder Helligkeitseinstellung. Schließlich weist die Steuerschaltung auch eine Zeitablauf- und Steuereinrichtung für die einzelnen Funktionsabläufe auf. Über eine Dateneingabeeinrichtung, z.B. ein extern zugänglichen Datenbus, können die unter verschiedenen Adressen in der digitalen Speichereinheit abgespeicherten Daten eingelesen, abgerufen oder verändert werden. Als Adresse dient beispielsweise die jeweilige Fernseh-Kanalnummer, die über eine Fernbedienungsschaltung aktiviert wird.

In der Offenlegungsschrift DE-A 34 27 852 (= US-A-4 544 911 und US-A-4 595 910) ist eine digitale Steuerschaltung für Abstimmsysteme in Fernsehempfängern beschrieben, die nach dem Frequenzsyntheseverfahren - also mit einer PLL-Regelschleife - arbeitet. Bei ihr wird die Tuner-Abstimmspannung ebenfalls mittels eines dynamischen Digital-Analogumsetzers erzeugt. Als Pulsdichtemodulator - in der Offenlegungsschrift Digital-Tastverhältnis-Steuerung genannt - wird ein akkumulierender Zähler verwendet, dessen Zähleingang mit einem aufzuaddierenden Datenwort gespeist ist und dessen Überlaufausgang das PDM-Signal liefert. Dabei tritt das Überlaufsignal in einem Betrachtungszeitraum im zeitlichen Mittel in demjenigen Verhältnis auf, das dem Zahlenverhältnis gleich ist, das aus dem Wert des zu addierenden Datenworts und der Anzahl der möglichen Zählerpositionen zu bilden ist.

Ein Nachteil derartiger analoger oder digitaler PLL-Regelschleifen in Abstimmsystemen ist indessen, daß sie zur Schwingungsunterdrückung und zur Glättung der Tuner-Abstimmspannung einen Tiefpaß mit sehr niedriger Grenzfrequenz oder einen Integrator benötigen, der den Wechsel von einer Frequenz auf eine andere verlangsamt. Dies ist dort hinderlich, wo ein einziger Tuner rasch zwischen mehreren Signalquellen umgeschaltet werden soll, z.B. bei einer Mehrfachbildwiedergabe im Fernsehempfänger oder bei einer Frequenz-Diversity-Empfangseinrichtung im Autoradio. Dauert die Umschaltung zu lang, geht ein Teil der Information verloren. Andererseits verbieten sich Mehrtunerausführungen im Unterhaltungsbereich meist aus Kostengründen.

In WO-A 88/01113 ist eine digitale Steuerschaltung für Abstimmsysteme beschrieben, die mittels einer Datenvorsetzeinrichtung und einer PLL-Schaltung einen raschen Wechsel der Tuner-Abstimmspannung ermöglicht, vgl. die Oberbegriffe der unabhängigen Ansprüche 1 und 9.

In WO-A-87/07794 ist eine ähnliche Schaltung zur Erzeugung einer Tuner-Abstimmspannung beschrieben, bei der die üblichen Funktionselemente der zugehörigen PLL-Schaltung ausführlich beschrieben sind.

In den beiden letztgenannten Schaltungen ist die Genauigkeit der Abstimmspannung jeweils von der Genauigkeit eines statischen Digital-Analog-Umsetzers abhängig, der mit einem Digitalwort der entsprechenden Stellenanzahl angesteuert wird. Die geforderte hohe Auflösung erfordert entsprechend aufwendige Digital-Analogumsetzer mit einer Genauigkeit von 12 bis 14 Bit. Monolithisch integriert ist diese Genauigkeit bekanntlich nur schwer zu realisieren.

Die bereits angesprochene Abstimmspannungserzeugung mit dynamischen Digital-Analogumsetzern, die insbesondere unter dem Begriff Pulsdichtemodulator ( =PDM) bekannt sind, erfordert bei einer hohen Auflösung eine hohe Zeitkonstante des nachgeschalteten Siebgliedes.

Es ist daher Aufgabe der Erfindung, eine verbesserte digitale Steuerschaltung für Abstimmsysteme anzugeben, die ohne hochauflösende statische Digital-Analog-Umsetzer auskommt und die auch keine Tiefpaßfilter mit großer Zeitkonstante für die Glättung bei der Verwendung hochauflösender dynamischer Digital-Analog-Umsetzer erfordert. Diese Aufgabe wird erfindungsgemäß mit den im unabhängigen Anspruch 1 oder unabhängigen Anspruch 9 angegebenen Merkmalen gelöst.

Das nach der Erfindung erforderliche Tiefpaßfilter weist lediglich eine kleine Zeitkonstante auf, wodurch die gewünschte Glättung der Ausgangssignale mit kleiner Einlaufzeit ermöglicht wird.

Ein weiterer Vorteil der Erfindung besteht darin, daß eine digitale Steuerschaltung für Abstimmsysteme angegeben wird, bei der möglichst viele Funktionen über bereits vorhandene Funktionseinrichtungen abwickelbar sind. Dies ist insbesondere dann von Wichtigkeit, wenn die digitale Steuerschaltung einen programmierbaren Mikroprozessor enthält, der diese Funktionen in Form von Mikroprogrammfolgen übernehmen kann.

Die durch die Erfindung erreichten Vorteile sind im wesentlichen darin zu sehen, daß die lange Einlaufzeit der Tiefpaßfilter durch das Vorsetzen auf einen Wert, der möglichst dicht im Bereich des eingeschwungenen Endwertes liegt, drastisch verkürzt wird. Dabei muß als weiterer Vorteil gesehen werden, daß die Erfindung das Ziel der kurzen Einlaufzeit erreicht, ohne die Schwingneigung zu verschlechtern. Es erweist sich im Gegenteil als besonderer Vorteil, daß die Nichtbeachtung der Einlaufzeit des Tiefpaßfilters geradezu einen zusätzlichen Freiheitsgrad für die Filterdimensionierung darstellt. Diese und weitere Vorteile ergeben sich im folgenden auch aus der ausführlichen Beschreibung der in der Zeichnung dargestellten Ausführungsbeispiele.

Die Erfindung wird nun anhand der Figuren der Zeichnung näher erläutert:
Fig.1 zeigt in Form eines schematisierten Blockschaltbildes eines Ausführungsbeispiel der digitalen Steuerschaltung für Abstimmsysteme, welche die Erfindung enthält.
Fig.2 zeigt schematisch ein bekanntes Ausführungsbeispiel eines Pulsdichtemodulators,
Fig.3 zeigt schematisch im Blockschaltbild als Ausführung der Erfindung nach Fig.1 einen Digital-Analogumsetzer hoher Auflösung, der sowohl das statische als auch das dynamische Umsetzungsprinzip in sich vereint,
Fig.4 zeigt schematisch eine weitergebildete Teilschaltung der Schaltungsanordnung nach Fig.3 und
Fig.5 zeigt einige grundsätzliche Signalverläufe der Schaltungsanordnung nach Fig.3 oder 4.

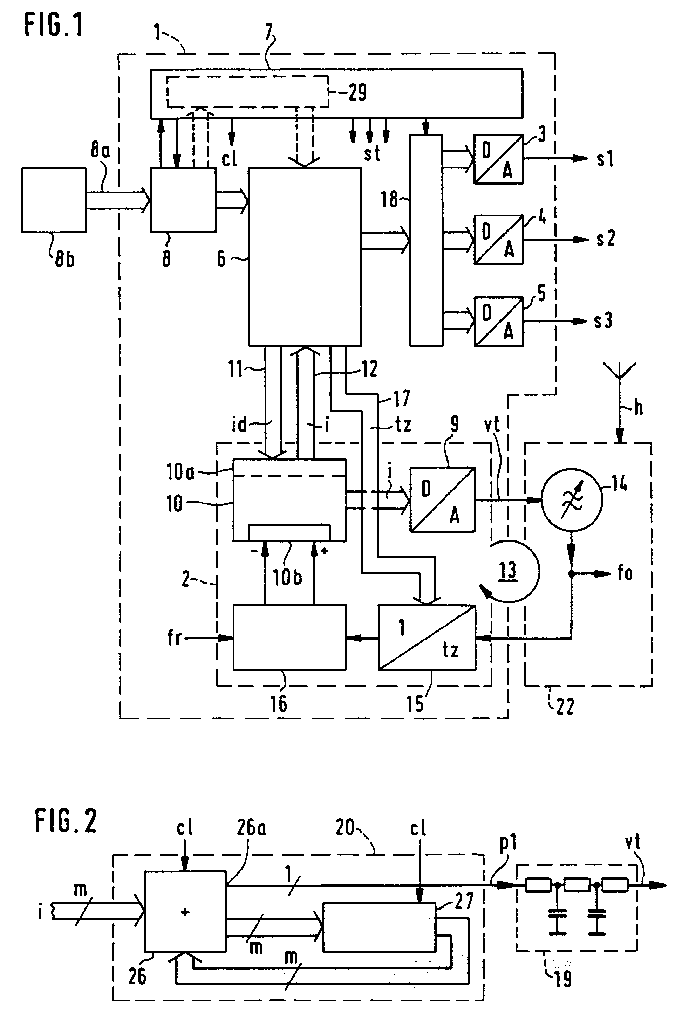

Fig.1 zeigt schematisch im Blockschaltbild ein grundsätzliches Ausführungsbeispiel welches die Erfindung enthält. Eine digitale Steuerschaltung 1 für Hochfrequenz-Abstimmsysteme, insbesondere für Fernsehempfänger, ist über eine Dateneingabeeinrichtung 8 mit einem externen Datenbus 8a verbunden, der beispielsweise extern von einem Fernbedienungsempfänger 8b gespeist ist. Über die Dateneingabeeinrichtung 8 werden der digitalen Steuerschaltung 1 unterschiedlichste Daten zugeführt, die entweder dem Kanalwechsel dienen oder bestimmte Funktions-Einstellspannungen s1, s2, s3 ändern, wie z.B. Lautstärke, Helligkeit usw... Mit den zugeführten Daten wird eine digitale Speichereinrichtung 6 angesteuert, welche aus den angesteuerten Speicherplätzen die eigentlichen internen Daten/Befehle ausliest. Es handelt sich dabei um einen Schreib-Lese-Speicher mit wahlfreiem Zugriff (= RAM). Die Funktions-Einstellspannungen s1, s2, s3 werden von ersten, relativ gering auflösenden Digital-Analogumsetzern 3, 4, 5 erzeugt, von denen in Fig.1 beispielsweise drei gezeichnet sind. Die Dateneingabe dieser Digital-Analogumsetzer erfolgt über einen Zwischenspeicher 18 aus der digitalen Speichereinrichtung 6.

Die zentrale Steuerfunktion in der digitalen Steuerschaltung 1 wird von einer Zeitablauf- und Steuereinrichtung 7 übernommen, welche Steuerbefehle st und einen zentralen Steuertakt cl für alle Teilschaltungen erzeugt. Die digitale Steuerschaltung 1 enthält schließlich als wesentlichen Funktionsteil eine Einrichtung 2 zur Erzeugung einer Tuner-Abstimmspannung vt. Dabei muß bekanntlich die Tuner-Abstimmspannung vt im Spannungsbereich zwischen 0,5 V und 33 V eine sehr hohe Auflösung aufweisen, beispielsweise 16 Bit (im Dualzahlcode). Dies erfordert ganz andere Digital-Analogumsetzer als bei der Erzeugung der Funktions-Einstellspannungen. Ein derartig hochauflösender Digital-Analogumsetzer läßt sich daher kaum als statischer Umsetzer mit einer monotonen Kennlinie realisieren. Daher wird in der Regel das Prinzip des in Fig.2 dargestellten dynamischen Umsetzers aufgegriffen, indem aus den digitalen Abstimmdaten ein pulsdichtemoduliertes Signal (= PDM-Signal) erzeugt wird, das mittels eines analogen Glättungsfilters geglättet wird. Derartige hochauflösende, dynamische Digital-Analogumsetzer erfordern als Glättungsfilter ein Tiefpaß mit sehr niedriger Grenzfrequenz, so daß beim Frequenzwechsel die Einlaufdauer ebenfalls lang werden kann. Dies widerspricht aber der angegebenen Aufgabenstellung der Erfindung.

Der Hauptgrund für die langsame Änderungsgeschwindigkeit der Tuner-Abstimmspannung vt liegt jedoch, wie bereits beschrieben, im eigentlichen Tiefpaßfilter oder Integrator der Phasenregelschleife bei Frequenzsynthesesystemen. Das in Fig.1 dargestellte Frequenzsynthessystem enthält eine Phasenregelschleife 13, welche einen Tuner 22 und die Einrichtung 2 zur Erzeugung der Tuner-Abstimmspanng vt umfaßt. Der schematisch dargestellte Tuner 22 enthält der Übersichtlichkeit wegen lediglich einen spannungsgesteuerten Oszillator (= VCO) 14, dessen Steuereingang von der Tuner-Abstimmspannung vt gespeist ist und dessen Ausgang ein hochfrequentes Oszillatorsignal fo mit der gewünschten lokalen Frequenz abgibt. Dem Tuner 22 ist ferner das hochfrequente Antennensignal h zugeführt. Das Oszillatorsignal fo ist auf den Frequenzteilereingang eines programmierbaren Frequenzteilers 15 geführt, dessen Steuereingang mit der Teilungszahl tz aus der digitalen Speichereinrichtung 6 gespeist ist. Der Ausgang des programmierbaren Frequenzteilers 15 ist mit dem Signaleingang eines Phasenvergleichers 16 verbunden, dessen Referenzeingang mit einem Referenzsignal fr fester Frequenz gespeist ist. Das Referenzsignal fr kann beispielsweise aus dem Systemtakt cl abgeleitet sein. Bei der Teilungszahl tz kann es sich auch um eine nichtganze Teilungszahl handeln.

Der Ausgang des Phasenvergleichers 16, dessen Ausgang ein Auf- oder Absignal erzeugt, ist mit dem entsprechenden Auf/Ab-Inkrementeingang 10b eines digitalen Integrators 10 verbunden, der den jeweiligen Integrationswert i, beispielsweise ein 16-stelliger Datenwert im Dualzahlencode, an einen zweiten Digital-Analogumsetzer 9 hoher Auflösung abgibt, dessen Ausgang die Tuner-Abstimmspannung vt liefert. Damit ist die Phasenregelschleife 13 geschlossen.

Der digitale Integrator 10 weist eine Vorsetzeinrichtung 10a auf, über die der digitale Integrator 10 zu jedem Zeitpunkt auf einen beliebig vorgebbaren Wert eingestellt werden kann. Dies erfolgt über eine erste Datenleitung 11, über die der Vorsetzdatenwert id dem digitalen Integrator 10 aus der digitalen Speichereinrichtung 6 zugeführt ist. Vorteilhafterweise wird dabei als Vorsetzdatenwert id derjenige Wert gewählt, der dem eingeschwungenen Integrationswert i entspricht, wenn die Phasenregelschleife 13 auf die richtige lokale Frequenz eingerastet ist. Wegen der nichtlinearen Kennlinie der Tunerdioden muß dieser Integrationswert i in einem eigenen Meßschritt bestimmt werden. Dies wird beispielsweise bei der erstmaligen Programmierung des gewünschten Kanals durchgeführt. Dabei wird der eingeschwungene Integrationswert i über die zweite Datenleitung 12 auf die digitale Speichereinrichtung 6 übertragen, und dort unter der Adresse dieses Kanals zusammen mit der zugehörigen Teilungszahl tz abgespeichert. Beim erneuten Aufruf dieses Kanals gelangt dieser gespeicherte Integrationswert i als Vorsetzdatenwert id über die erste Datenleitung 11 auf die Vorsetzeinrichtung 10a des digitalen Integrators 10.

Damit befindet sich die Phasenregelschleife 13 dicht im Bereich des eingeschwungenen Zustands und die Frequenz des VCO 14 ist nahezu verzögerungsfrei umgeschaltet worden. Allenfalls ist eine geringfügige Korrektur über wenige Inkrementierschritte am Auf/Ab-Inkrementeingang 10b erforderlich.

Ohne die Vorsetzeinrichtung 10a würde sich der endgültige Integrationswert i erst nach einer Vielzahl von Inkrement- oder Dekrementschritten, einstellen. Die Einlaufzeit wäre auch ferner von der Sprunggröße der Tuner-Abstimmspannung vt abhängig. Die erste und die zweite Datenleitung 11, 12 sind als eine bidirektionale Datenleitung zusammenlegbar.

Für den relativ langsamen Suchlauf ist die Vorsetzung des digitalen Integrators 10 nicht erforderlich, weil der Integrationswert i nur über Inkrementschritte geändert wird. Zudem erfolgt der Suchlauf meist bei erstmaliger Inbetriebnahme, bei der die digitale Speichereinrichtung 6 sowieso noch keine Vorsetzdatenwerte id enthält.

Als zweiter Digital-Analogumsetzer 9 wäre ein statischer Umsetzer ideal, dessen Kennlinie monoton ist und dessen differentieller Fehler kleiner als ein LSB (= least significant bit) ist. Ein derartiger Digital-Analogumsetzer könnte ohne analoges Glättungsfilter direkt den VCO 14 ansteuern. Dabei müßte die Kennlinie nicht einmal linear sein.

In Fig.2 ist schematisch als Blockschaltbild ein dynamischer Digital-Analogumsetzer dargestellt, nämlich ein bekannter Pulsdichtemodulator 20, der im wesentlichen aus einem Akkumulator 26, 27 besteht und der als Ausgang lediglich einen Überlaufausgang 26a aufweist. Als Beispiel ist angenommen, daß der Integrationswert i ein m-stelliges Datenwort im Dualzahlcode darstellt, das dem ersten Dateneingang eines m-stelligen Addierers 26 zugeführt ist. Der m-stellige Ausgang dieses Addierers 26 ist mit dem Eingang eines Akkumulatorspeichers 27 verbunden, dessen Ausgang an den m-stelligen zweiten Eingang des Addierers 26 angeschlossen ist. Der Akkumulator 26, 27 des Pulsdichtemodulators 20 ist von Systemtakt cl getaktet. Der Überlaufausgang 26a des Addierers 26 liefert das pulsdichtemodulierte Signal (= PDM-Signal) p1.

Jedesmal, wenn die Summe der dem m-stelligen Addierer 26 zugeführten Daten größer als der m-stellige Datenumfang im Dualzahlcode ist, wird am Überlaufausgang 26a eine logische "1" ausgegeben. Wie bereits oben angegeben, tritt im Mittel die logische "1" in einem zahlenmäßigen Verhältnis auf, das dem Verhältnis aus dem jeweiligen Integrationswert i und dem maximalen Datenumfang entspricht, der durch die Stellenanzahl m bestimmt wird. Ein Glättungstiefpaß 19, der aus mehreren hintereinandergeschalteten RC-Gliedern besteht, dient der Glättung des PDM-Signals p1. Am Ausgang des Glättungstiefpasses 19 ist dann die konstante Tuner-Abstimmspannung vt abgreifbar. Die Zeitkonstante des Glättungstiefpasses 19 hängt direkt von der Langzeitperiode des PDM-Signals p1 ab. Je höher die Auflösung des dynamischen Digital-Analogwandlers ist, desto größer ist die Stellenanzahl m des Addierers 26 und desto größer kann auch die Langzeit- oder Wiederholungsperiode des PDM-Signals p1 werden.

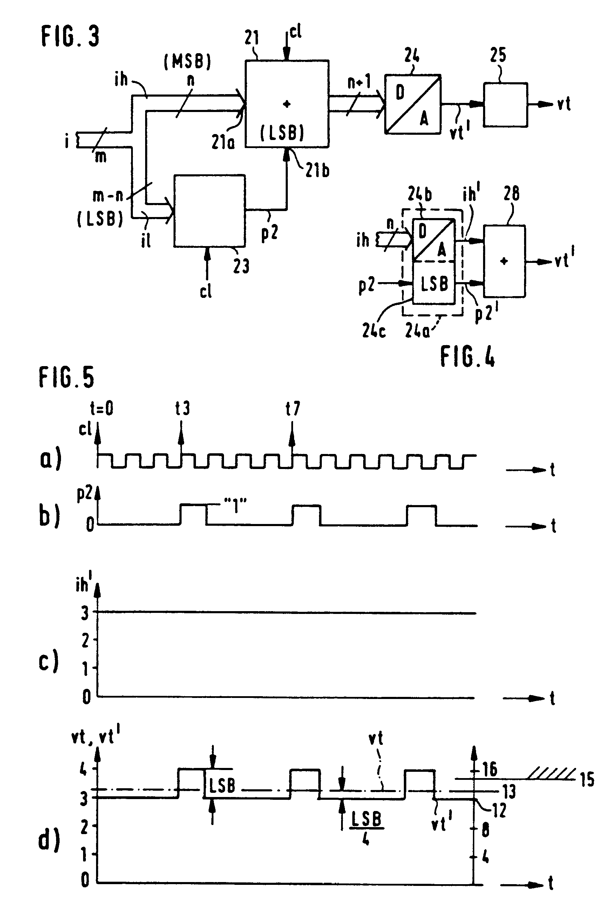

In Fig.3 ist eine erfindungsgemäße-Ausführung eines dynamischen Digital-Analogumsetzers von Fig. 1 schematisch als Blockschaltbild dargestellt, der trotz hoher Auflösung nur ein analoges Glättungsfilter 25 kleiner Zeitkonstante benötigt, das zudem analog vorgesetzt wird. Der m-stellige Integrationswert i (im Dualzahlcode) ist dabei in zwei Datenteile aufgespalten, wobei n höherwertige Stellen den höherwertigen Datenteil ih und die anderen m-n restlichen Stellen den niederwertigen Datenteil il bilden. Mit dem höherwertigen Datenteil ih sind die n Stellen des ersten Dateneingangs 21a eines (n+1)-stelligen Addierers 21 gespeist, wobei sich die n+1 Stellen auf den Datenumfang des Ausganges beziehen. Die niederwertigste Stelle des höherwertigen Datenteils ih ist dabei an die LSB-Stelle des ersten Dateneingangs 21a angeschlossen. Mit dem niederwertigen Datenteil il ist ein (m-n)-stelliger Pulsdichtemodulator 23 gespeist, dessen ausgangsseitiges PDM-Signal p2 dem zweiten Dateneingang 21b, und zwar der LSB-Stelle des (n+1)-stelligen Addierers 21 zugeführt ist. Da die Summe aus dem höherwertigen Datenteil ih und dem PDM-Signal p2 maximal 2ⁿ sein kann, mit n Stellen aber lediglich der Wert 2ⁿ-1 realisierbar ist, muß im Dualzahlcode das Ausgangssignal des Addierers 21 n+1 Stellen aufweisen.

Ein 16-stelliger (m= 16) Integrationswert i wird z.B. vorteilhaft so aufgeteilt, daß die sechs höherwertigen Stellen (n= 6) statisch und die restlichen zehn niedrigwertigen Stellen (m-n= 10) dynamisch verarbeitet werden.

Sollen alle möglichen 2ⁿ Werte digitalisiert werden, erfordert dies einen (n+1)-stelligen Digital-Analogumsetzer 24. Das Ausgangssignal dieses Umsetzers 24 schwankt um genau ein LSB im Takt des PDM-Signals p2. Diese geringfügige Pulsstörung läßt sich leicht mittels eines Glättungsfilters 25 kleiner Zeitkonstante einebnen, so daß aus der ungeglätteten Tuner-Abstimmspannung vt′ ein rippelfreies Signal wird.

Das Glättungsverhalten wird durch folgende zwei PDM-Signaleigenschaften begünstigt:
1. Im PDM-Signal p2 weist die Rippel-Amplitude nur die Höhe von einem LSB-Wert auf, während bei dem a.a.0. beschriebenen ungeglätteten PDM-Signal die Rippel-Amplitude 33 V beträgt.
2. Die Langzeit- oder Wiederholungsperiode des (m-n)-stelligen Pulsdichtemodulators 23 ist durch die geringe Stellenanzahl m-n wesentlich kürzer als bei einem Pulsdichtemodulator mit der vollen Stellenanzahl m.

Durch diese erfindungsgemäße Maßnahme läßt sich ein Digital-Analogumsetzer hoher Auflösung realisieren, der für den Grobeinstellbereich das statische und für den Feineinstellbereich das dynamische Umsetzungsprinzip vorteilhaft vereinigt. Von Vorteil sind insbesondere die geringe Stellenanzahl des statischen Digital-Analogumsetzers 24 und die zur Glättung ausreichende kleine Zeitkonstante, die durch ein einfaches Glättungsfilter 25 realisiert ist. Der statisch eingestellte Grobeinstellbereich wirkt zudem als analoge Vorsetzung des Glättungsfilters.

Ein derartiger Digital-Analogumsetzer läßt sich mit Vorteil in der digitalen Steuerschaltung 1 für Abstimmsysteme verwenden, bei der die rasch umschaltbare Tuner-Abstimmspannung vt durch die Einrichtung 2 nach dem Spannungssyntheseverfahren gebildet wird. Denn die kleine Zeitkonstante des analogen Glättungsfilters 25 stellt dann wie bei der Frequenzsynthese die einzige Verzögerung dar, die indessen nicht stört.

Fig.4 zeigt schematisch als Ausschnitt eine besonders vorteilhafte Weiterbildung der Schaltungsanordnung nach Fig.3. Bei gleicher Auflösung der Tuner-Abstimmspannung vt läßt sich nämlich der (n+1)-stellige Digital-Analogumsetzer 24 nach Fig.3 durch einen n-stelligen Digital-Analogumsetzer 24a ersetzen, der lediglich mit einer zusätzlichen, separaten LSB-Stufe 24c ausgerüstet sein muß. In diesem Fall speisen die n Stellen des höherwertigen Datenteils ih direkt den Eingang des eigentlichen n-stelligen Digital-Analogumsetzers 24b, während das PDM-Signal p2 dem Eingang der separaten LSB-Stufe 24c zugeführt ist. Das Ausgangssignal des eigentlichen n-stelligen Digital-Analogumsetzers 24b ist ein konstanter Grundwert ih′, der dem ersten Eingang eines analogen Addierers 28 zugeführt ist. Der Ausgang der separaten LSB-Stufe 24c liefert ein amplitudenrichtiges PDM-Signal p2′, das dem zweiten Eingang des analogen Addierers 28 zugeführt ist. Das amplitudenrichtige PDM-Signal p2′ weist unabhängig vom Pegel des Pulsdichtemodulators 23 einen genauen LSB-Pegelwert auf. Das Ausgangssignal des analogen Addierers 28 entspricht genau der ungeglätteten Tuner-Abstimmspannung vt′ von Fig.3.

In Fig.5 ist schließlich anhand einiger typischer Signalverläufe die Funktionsweise dieser Schaltungsanordnung nach Fig.3 oder 4 verdeutlicht. Als Beispiel ist vereinfachend angenommen, daß m=4 und n=2 Stellen im Dualzahlcode umfaßt. Als zugeführter Integrationswert i wird die Dualzahl 1101 mit dem Dezimalwert 13 angenommen. Der höherwertige Datenteil ih besteht somit aus der Dualzahl 11 (Dezimalwert 3) und der niederwertige Datenteil il aus der Dualzahl 01 (Dezimalwert 1).

Im Zeitdiagramm 5a ist der Systemtakt cl dargestellt, dessen Impuls-Pausenverhältnis 1:1 beträgt.

Im Zeitdiagramm 5b ist das PDM-Signal p2 des (m-n)-stelligen Pulsdichtemodulators 23 dargestellt. Im angenommenen Beispiel beträgt dessen Stellenanzahl 2, also m-n=2, wodurch vier Positionen unterscheidbar sind. Zum Zeitpunkt t=0 ist als Zählerinhalt des Pulsdichtemodulators 23 die Dualzahl 01 (Dezimalwert 1) angenommen. Damit ergibt sich beim dritten Taktimpuls t3 ein Überlauf, der als logische "1" im PDM-Signal p2 erscheint. Dieser Überlauf erscheint nach jeweils vier Taktimpulsen. Dies entspricht dem Verhältnis des zugeführten Datenwerts, nämlich dem Dezimalwert 1, zur Anzahl der möglichen Unterscheidungsstufen, nämlich vier im dargestellten Beispiel.

Im Zeitdiagramm 5c ist der konstante Grundwert ih′ mit dem Dezimalwert 3 dargestellt. Als eigentliches Signal ist dieser konstante Grundwert ih′ in der Schaltungsanordnung nach Fig.3 zwar nicht vorhanden, ergibt sich jedoch ohne weiteres als gedanklicher Zwischenschritt aus dem höherwertigen Datenteil ih oder direkt als Signal aus Fig.4.

Das Zeitdiagramm 5d zeigt schließlich das ungeglättete Tuner-Abstimmsignal vt′ aus Fig.3 und Fig.4, das aus der Kombination des konstanten Grundwertes ih′ und des amplitudenrichtigen PDM-Signal p2′ besteht. Dabei sind der konstante Grundwert ih′ und das amplitudenrichtige PDM-Signal p2′ als reale Signale lediglich in Fig.4 enthalten. Zum Zeitpunkt t3, t7 springt die ungeglättete Tuner-Abstimmspannung vt′ vom Dezimalwert 3 um ein LSB-Wert auf den Dezimalwert 4. Das gleiche wiederholt sich alle vier Taktimpulse. Bei der Glättung wird das arithmetische Mittel gebildet, so daß die Tuner-Abstimmspannung vt, die als strichpunktierte Linie gezeichnet ist, um (LSB)/4 oberhalb des Dezimalwertes 3 liegt.

Im Zeitdiagramm 5d sind auf der linken Seite als Abszissenwerte die Ausgangswerte in LSB-Einheiten der Digital-Analogumsetzer 24, 24a dargestellt. Auf der rechten Abszisse sind alle Ausgangswerte der Wandleranordnung nach Fig.3 oder Fig.4 als unterscheidbare Stufen von 0 bis 15 durchnummeriert. Im Zeitdiagramm nach Fig.5d ist zu erkennen, daß die ungeglättete Tuner-Abstimmspannung vt′ in Fig.3 und Fig.4 zeitweilig höhere Werte einnehmen kann, als die maximal mögliche Tuner-Abstimmspannung, die dem Dezimalwert 15 entsprechen würde.

Eine besonders vorteilhafte Weiterbildung der Erfindung besteht darin, daß die digitale Steuerschaltung 1 eine Vielzahl von Einrichtungen 2 zur Erzeugung verschiedener Tuner-Abstimmspannungen enthält. Dies ermöglicht die Verwendung von nicht gepaarten Tunerdioden, indem die unterschiedlichen Abstimmdaten dieser Tunerdioden unter einer gemeinsamen Adresse in der digitalen Speichereinrichtung 6 abgelegt sind. Für jeden digitalen Integrator 10 oder digitalen Tiefpaß ist unter der gleichen Adresse dann auch noch der jeweilige Vorsetzdatenwert id abzuspeichern.

Um die unterschiedlichsten Anwendungsbedürfnisse zu befriedigen, ist es vorteilhaft, die digitale Steuerschaltung 1 in der Zeitablauf- und Steuereinrichtung 7 mit einem programmierbaren Mikroprozessor 29 zu versehen, der beispielsweise beim Mehrkanalempfang von Fernsehsignalen das zyklische Umschalten der Empfangskanäle steuert. Die erforderlichen Daten, wie die Kanalnummern, Wiedergabefolge, Verweildauer oder Zyklusdauer lassen sich dann über die Dateneingabeeinrichtung als Programm eingeben. Die Verwendung eines Programms ermöglicht, daß mit einer einzigen digitalen Steuerschaltung 1 unterschiedlichste Anwendungsfälle abdeckbar sind. Dies stellt speziell im Konsumbereich eine sehr wirtschaftliche Lösung dar.

Die im Digitalbereich mögliche Mehrfachausnutzung von Funktionsteilen im Multiplexbetrieb läßt sich ebenfalls anwenden. Noch vorteilhafter ist es, wenn diese Funktionsteile gar nicht erst als Hardware-Schaltungen realisiert sind sondern als Mikroprogramm in Software-Technik vorliegen. Dies bietet sich insbesondere dort an, wo bereits ein Mikroprozessor 29 in der digitalen Steuerschaltung 1 vorhanden ist, vgl. Fig.1. In der Regel ist seine Rechengeschwindigkeit so hoch, daß er derartige Funktionen ohne weiteres übernehmen kann. Der digitale Integrator 10 und die ersten und zweiten Datenleitungen 11, 12 sind dann beispielsweise nur in Form eines Mikroprogramms vorhanden, das im Mikroprozessor Daten zwischen dem Speicher und der arithmetischen Logikeinheit (= ALU) bewegt. Beim Vorsetzen wird dann der Vorsetzdatenwert id in die ALU geschrieben. Genau so kann der Addierer 21 und der Pulsdichtemodulator 23 als Mikroprogrammfolge realisiert sein.

So läßt sich der Schaltungsaufwand klein halten, auch wenn eine Vielzahl von Tuner-Abstimmspannungen vt erzeugt werden soll. Bis auf die Ausgangsstufen der Digital-Analogumsetzer 9, 24, 24a sind die Funktionsteile dann nur einmal real vorhanden, oder gar in Software-Technik realisiert.

## Patentansprüche

1. Digitale Steuerschaltung (1) für Abstimmsysteme, welche folgende Komponenten enthält:
- eine Einrichtung (2) mit einem Digital-Analogumsetzer (9; 24), auch als zweiter Digital-Analogumsetzer bezeichnet, zur Erzeugung einer Tuner-Abstimmspannung (vt),
- eine digitale Speichereinrichtung (6) zur Speicherung von Daten für die Tuner-Abstimmspannung (vt),
- eine Zeitablauf- und-Steuereinrichtung (7),
- eine Dateneingabeeinrichtung (8) und
- eine Datenvorsetzeinrichtung (10a) in der Einrichtung (2), die über Datenverbindungen mit der Speichereinrichtung (6) gekoppelt ist welche am Ausgang einen Vorsetzdatenwert (id) liefert, welcher dem eingeschwungenen Zustand der entsprechenden Tuner-Abstimmspannung entspricht,
gekennzeichnet durch folgende Merkmale:
- der zweite Digital-Analogumsetzer (9), der in der Einrichtung (2) enthalten und von einem digitalen Integrator (10) gesteuert ist, ist in einen statisch umsetzenden Grob- und in einen dynamisch umsetzenden Feineinstellbereich aufgeteilt,
- der digitale Integrator (10) enthält eine Vorsetzeinrichtung (10a), die über eine erste Datenleitung (11) aus der digitalen Speichereinrichtung (6) gespeist ist und liefert am Ausgang einen der jeweiligen Tuner-Abstimmspannung (vt) zugeordneter Integrationswert (i), der als m-stellige Dualzahl codiert ist,
- der jeweilige Vorsetzdatenwert (id) ist zusammen mit den Daten für die zugehörige Tuner-Abstimmspannung (vt) unter derselben Adresse abgespeichert und der Vorsetzdatenwert (id) entspricht dem eingeschwungenen Integrationswert bei dieser Tuner-Abstimmspannung (vt),
- der Integrationswert (i) ist ferner über eine zweite Datenleitung (12) in die digitale Speichereinrichtung (6) einschreibbar, wobei dieser Integrationswert (i) unter derselben Adresse wie die zugehörige Tuner-Abstimmspannung (vt) abgelegt ist und wobei dieser Integrationswert (i) bei einem erneuten Aufruf als Vorsetzdatenwert (id) dient,
- das Vorsetzen des digitalen Integrators (10) erfolgt mit jedem gezielten Wechsel der Tuner-Abstimmspannung (vt),
- ein n-stelliger höherwertiger Datenteil (ih) des Integrationswertes (i) ist n höherwertigen Stellen des ersten Dateneingangs (21a) eines Addierers (21) zugeführt,
- der restliche, (m-n)-stellige niedrigwertige Datenteil (il) des Integrationswertes (i) ist dem Dateneingang eines Pulsdichtemodulators (23) zugeführt, der von einem konstanten Systemtakt (c1) geschaltet ist,
- das Ausgangssignal des Pulsdichtemodulators (23) speist die niedrigstwertige Stelle (LSB) des zweiten Dateneingangs (21b) des Addierers (21), dessen (n+1)-stelliger Ausgang mit dem Eingang eines statischen, (n+1)-stelligen Digital-Analogumsetzer (24) verbunden ist, und
- das Ausgangssignal (vt') des (n+1)-stelligen Digital-Analogumsetzers (24) ist mittels eines analogen Tiefpaßfilters kleiner Zeitkonstante, dem Glättungsfilter (25), geglättet und bildet die Tuner-Abstimmspannung (vt) mit einer Auflösung von 2^{m}-1 Stufen.

2. Digitale Steuerschaltung (1) nach Anspruch 1, dadurch gekennzeichnet, daß die Einrichtung (2) zur Erzeugung der Tuner-Abstimmspannung (vt) ein Frequenzsynthesesystem mit einer Phasenregelschleife (13) ist, in der signalflußmäßig hintereinandergeschaltet sind:
ein spannungsgesteuerter Oszillator (14), der als hochfrequenter lokaler Oszillator dient, ein programmierbarer Frequenzteiler (15), ein Phasenvergleicher (16), dessen Referenzeingang mit einem Referenzsignal (fr) fester Frequenz gespeist ist, ein digitaler Integrator (10), dessen Auf/Ab-Inkrementeingang (10b) mit dem Ausgang des Phasenvergleichers (16) verbunden ist und schließlich der zweite Digital-Analogumsetzer (9), dessen Ausgang an den Steuereingang des VCO (14) angeschlossen ist.

3. Digitale Steuerschaltung (1) nach Anspruch 2, dadurch gekennzeichnet, daß beim Wechsel der Tuner-Abstimmspannung (vt) im Suchlaufbetrieb die Vorsetzung des digitalen Integrators (10) unterbunden ist und daß der Integrationswert (i) lediglich über feste Inkrementschritte geändert ist, die über den Auf/Ab-Inkrementeingang (10b) zugeführt sind.

4. Digitale Steuerschaltung (1) nach einem der Ansprüche 1 bis 3, dadurch gekennzeichnet, daß sie eine Vielzahl von Einrichtungen (2) zur Erzeugung verschiedener Tuner-Abstimmspannnungen (vt) enthält, wobei die unterschiedlichen Abstimmdaten und die zugehörigen Vorsetzdatenwerte (id) für den Betrieb von nicht gepaarten Tunerdioden unter einer gemeinsamen Adresse abgelegt sind.

5. Digitale Steuerschaltung (1) nach einem der Ansprüche 1 bis 4, gekennzeichnet durch folgende Merkmale:
- die digitale Steuerschaltung (1) dient der Kanalumschaltung von Fernsehempfängern bei Mehrkanalempfang und gleichzeitiger Mehrfachbildwiedergabe und
- das zyklische Umschalten der Empfangskanäle ist durch die Zeitablauf- und Steuereinrichtung (7) gesteuert, wobei die erforderlichen Daten, wie Kanalnummern, Reihenfolge, Verweildauer oder Zyklusdauer, über die Dateneingabeeinrichtung (8) eingegeben sind.

6. Digitale Steuerschaltung (1) nach einem der Ansprüche 2 bis 5, gekennzeichnet durch folgende Merkmale:
- die Zeitablauf- und Steuereinrichtung (7) enthält einen Mikroprozessor (29), der über die Dateneingabeeinrichtung (8) programmierbar und ansteuerbar ist und
- der digitale Integrator (10) und die erste und zweite Datenleitung (11, 12) sind in Software-Technik realisiert.

7. Digitale Steuerschaltung (1) nach einem der Ansprüche 1 bis 6, dadurch gekennzeichnet, daß der Addierer (21) und der Pulsdichtemodulator (23) in Software-Technik realisiert sind.

8. Digitale Steuerschaltung (1) nach einem der Ansprüche 1 bis 7, dadurch gekennzeichnet, daß der Pulsdichtemodulator (23) aus einem (m-n)-stelligen Zähler mit Überlaufausgang besteht, dessen (m-n)-stelliger Dateneingang mit dem niederwertigen Datenteil (il) gespeist ist und dessen Überlaufsignal als pulsdichtemoduliertes Signal, auch PDM-Signal (p2) bezeichnet, der LSB-Stelle des zweiten Dateneingangs (21b) des Addierers (21) zugeführt ist.

9. Digitale Steuerschaltung (1) gemäß Anspruch 1 bei der die Weiterverarbeitung des n-stelligen, höherwertigen Datenteils (ih) des Integrationswertes (i)
durch folgende Merkmale gekennzeichnet ist:
- der n-stellige, höherwertige Datenteil (ih) des Integrationswertes (i) ist dem Dateneingang eines statischen, n-stelligen Digital-Analogumsetzers (24a) zugeführt, der als Funktionseinheiten einen eigentlichen, n-stelligen Digital-Analogumsetzer (24b) und eine separate LSB-Stufe (24c) enthält,
- der restliche, (m-n)-stellige niedrigwertige Datenteil (il) des Integrationswertes (i) ist dem Dateneingang eines Pulsdichtemodulators (23) zugeführt, der von einem konstanten Systemtakt (c1) geschaltet ist,
- das Ausgangssignal (p2) des Pulsdichtemodulators (23) ist der separaten LSB-Stufe (24c) zugeführt und
- der Ausgang des eigentlichen, n-stelligen Digital-Analogumsetzers (24b) und der Ausgang der separaten LSB-Stufe (24c) sind auf jeweils einen Eingang eines analogen Addierers (28) geschaltet, dessen Ausgangssignal eine ungeglättete Tuner-Abstimmspannung (vt′) ist, die mittels eines analogen Tiefpaßfilters kleiner Zeitkonstante, dem Glättungsfilter (25), geglättet wird und die Tuner-Abstimmspannung (vt) mit einer Auflösung von 2^{m}-1 Stufen bildet.

10. Digitale Steuerschaltung (1) nach einem der Ansprüche 1 bis 9, dadurch gekennzeichnet, daß mehrere erste Digital-Analogumsetzer (3, 4, 5) zur Erzeugung mehrerer Funktions-Einstellspannungen (s1, s2, s3) dienen.

## Claims

1. A digital control circuit (1) for tuning systems, comprising the following components:
- a device (2) with a digital-to-analog converter (9; 24), also referred to as second digital-to-analog converter, for generating a tuning voltage (vt),
- a digital memory device (6) for storing data for the tuning voltage (vt),
- a timing and control unit (7),
- a data input device (8), and
- a data presetting device (10a) in the device (2) which is coupled via data links to the memory device (6), which provides at the output a preset data value (id) corresponding to the steady state of the respective tuning voltage,
characterized by the following features:
- The second digital-to-analog converter (9), which is contained in the device (2) and is controlled by a digital integrator (10), is divided into a statically converting coarse adjustment portion and a dynamically converting fine adjustment portion;
- the digital integrator (10) includes a presetting device (10a) which is fed from the digital memory device (6) via a first data line (11), and provides at the output an integration value (i) assigned to the respective tuning voltage (vt), said integration value being encoded as an m-digit binary number;
- the respective preset data value (id) and the data for the associated tuning voltage (vt) are stored at the same address, and the preset data value (id) is equal to the steady-state integration value at said tuning voltage (vt);
- the integration value (i) can also be written via a second data line (12) into the digital memory device (6), where it is stored at the same address as the associated tuning voltage (vt), said integration value (i) serving as the preset data value (id) when being called;
- the presetting of the digital integrator (10) occurs on each selective change of the tuning voltage (vt);
- an n-bit high-order data part (ih) of the integration value (i) is fed to the n high-order-bit terminals of the first data input (21a) of an adder (21);
- the remaining, (m-n)-bit low-order data part (il) of the integration value (i) is fed to the data input of a pulse-density modulator (23) which is switched by a constant system clock (cl);
- the output of the pulse-density modulator (23) feeds the least-significant-bit (LSB) terminal of the second data input (21b) of the adder (21), whose (n+1)-bit output is coupled to the input of a static, (n+l)-bit digital-to-analog converter (24); and
- the output (vt') of the (n+1)-bit digital-to-analog converter (24) is smoothed by means of an analog low-pass filter with a short time constant, the smoothing filter (25), and forms the tuning voltage (vt) with a resolution of 2^{m}-1 steps.

2. A digital control circuit (1) as claimed in claim 1, characterized in that the device (2) for generating the tuning voltage (vt) is a frequency synthesis system with a phase-locked loop (13) in which the following elements are connected in cascade:
a voltage-controlled oscillator (14) serving as a high-frequency local oscillator, a programmable frequency divider (15), a phase comparator (16) having a fixed-frequency reference signal (fr) applied to its reference input, a digital integrator (10) having its increment/ decrement input (10b) connected to the output of the phase comparator (16), and the second digital-to-analog converter (9), whose output is coupled to the control input of the VCO (14).

3. A digital control circuit (1) as claimed in claim 2, characterized in that, when the tuning voltage (vt) changes during search tuning, the presetting of the digital integrator (10) is inhibited, and that the integration value (i) is changed only via fixed increment/decrement steps which are applied via the increment/decrement input (10b).

4. A digital control circuit (1) as claimed in any one of claims 1 to 3, characterized in that it includes a plurality of devices (2) for generating different tuning voltages (vt), the different tuning data and the associated preset data values (id) for the operation of nonpaired tuning diodes being stored at a common address.

5. A digital control circuit (1) as claimed in any one of claims 1 to 4, characterized by the following features:
- The digital control circuit (1) serves to switch channels in television receivers during multichannel reception and simultaneous multipicture display, and
- the cyclic switching of the received channels is controlled by the timing and control unit (7), into which the necessary data, such as channel numbers, sequence, dwell time, or cycle duration, is fed via the data input device (8).

6. A digital control circuit (1) as claimed in any one of claims 2 to 5, characterized by the following features:
- The timing and control unit (7) includes a microprocessor (29) which is programmable and controllable via the data input device (8), and
- the digital integrator (10) and the first and second data lines (11, 12) are implemented in software.

7. A digital control circuit (1) as claimed in any one of claims 1 to 6, characterized in that the adder (21) and the pulse-density modulator (23) are implemented in software.

8. A digital control circuit (1) as claimed in any one of claims 1 to 7, characterized in that the pulse-density modulator (23) is an (m-n)-bit counter with an overflow output whose (m-n)-bit data input is fed with the low-order data part (il), and whose overflow signal is applied as a pulse-density-modulated signal, also referred to as PDM signal (p2), to the LSB terminal of the second data input (21b) of the adder (21).

9. A digital control circuit (1) as claimed in claim 1 wherein the processing of the n-bit high-order data part (ih) of the integration value (i)
is characterized by the following features:
- The n-bit high-order data part (ih) of the integration value (i) is fed to the data input of a static, n-bit digital-to-analog converter (24a) which contains an n-bit digital-to-analog converter proper (24b) and a separate LSB stage (24c) as functional units;
- the remaining, (m-n)-bit low-order data part (il) of the integration value (i) is fed to the data input of a pulse-density modulator (23) which is switched by a constant system clock (cl);
- the output (p2) of the pulse-density modulator (23) is fed to the separate LSB stage (24c); and
- the output of the n-bit digital-to-analog converter proper (24b) and the output of the separate LSB stage (24c) are coupled to respective inputs of an analog adder (28) whose output is an unsmoothed tuning voltage (vt′) which is smoothed by means of an analog low-pass filter with a short time constant, the smoothing filter (25), and forms the tuning voltage (vt) with a resolution of 2^{m}-1 steps.

10. A digital control circuit (1) as claimed in any one of claims 1 to 9, characterized in that two or more first digital-to-analog converters (3, 4, 5) serve to generate two or more function control voltages (sl, s2, s3).

## Revendications

1. Circuit de commande numérique (1) pour des systèmes de réglage d'accord, qui contient les composants suivants :
- un dispositif (2) comportant un convertisseur numérique/analogique (9 ; 24), également désigné sous l'expression second convertisseur numérique/analogique, pour la production d'une tension de réglage d'accord (vt) de syntoniseur ;
- un dispositif de mémoire numérique (6) pour mémoriser des données pour la tension de réglage d'accord (vt) de syntoniseur ;
- un dispositif d'exécution et de commande temporelle (7) ;
- un dispositif (8) d'entrée de données ; et
- un dispositif (10a) de prépositionnement de données situé dans le dispositif (2) et qui est accouplé par l'intermédiaire de liaisons de transmission de données au dispositif de mémoire (6) et délivre, à sa sortie, une valeur de donnée de prépositionnement (id), qui correspond à l'état stabilisé de la tension de réglage d'accord correspondante de syntoniseur ;
caractérisé par les caractéristiques suivantes :
- le second convertisseur numérique/analogique (9), qui est contenu dans le dispositif (2) et est commandé par un intégrateur numérique (10), est divisé en une plage de réglage approximatif, qui réalise une conversion statique, et à une plage de réglage précis qui réalise une conversion dynamique ;
- l'intégrateur numérique (10) contient un dispositif (10a) de prépositionnement, qui est alimenté par l'intermédiaire d'une première ligne (11) de transmission de données, à partir du dispositif de mémoire numérique (6) et délivre, à sa sortie, une valeur d'intégration (i), qui est associée à la tension de réglage d'accord respective de syntoniseur (vt) et est codée sous la forme d'un nombre binaire à m chiffres ;
- la valeur respective de données de prépositionnement (id) est mémorisée, conjointement avec les données pour la tension de réglage d'accord associée de syntoniseur (vt), à la même adresse et la valeur de données de pré-positionnement (id) correspond à la valeur d'intégration stabilisée, pour cette tension de réglage d'accord de syntoniseur (vt) ;
- la valeur d'intégration (i) peut en outre être enregistrée, par l'intermédiaire d'une seconde ligne (12) de transmission de données, dans le dispositif de mémoire numérique (6), cette valeur d'intégration (i) étant mémorisée à la même adresse que la tension de réglage d'accord associée de syntoniseur (vt), et cette valeur d'intégration (i) étant utilisée en tant que valeur de donnée de prépositionnement (id), lors d'un appel renouvelé ;
- le prépositionnement de l'intégrateur numérique (10) s'effectue avec chaque changement voulu de la tension de réglage d'accord de syntoniseur (vt) ;
- une partie de données (ih) comportant n chiffres de poids supérieur de la valeur d'intégration (i) est envoyée à n emplacements, correspondant à des poids supérieurs, de la première entrée de données (21a) d'un additionneur (21)
- la partie de données restante (i1), qui comporte (m-n) chiffres de poids faible, de la valeur de l'intégration (i) est envoyée à l'entrée de données d'un modulateur (23) de densité d'impulsions, qui est activé par une cadence constante (cl) du système ;
- le signal de sortie du modulateur (23) de densité d'impulsions fournit le chiffre de poids le plus faible (LSB) de la seconde entrée de données (21b) de l'additionneur (21), dont la sortie à (n+1) chiffres est reliée à l'entrée d'un convertisseur numérique/analogique statique (24) à (n+1) chiffres ; et
- le signal de sortie (vt′) du convertisseur numérique/analogique (24) à (n+1) chiffres est lissé au moyen d'un filtre passe-bas analogique possédant une faible constante de temps, le filtre de lissage (25), et forme la tension de réglage d'accord de syntoniseur (vt) avec une résolution de 2^{m}-1 étages.

2. Circuit de commande numérique (1) selon la revendication 1, caractérisé en ce que le dispositif (2) servant à produire la tension de réglage d'accord de syntoniseur (vt) est un système de synthèse de fréquences comportant une boucle de régulation de phase (13), dans laquelle sont branchés successivement, dans le sens du flux de transmission des signaux :
un oscillateur (14) commandé par la tension, qui sert d'oscillateur local à haute fréquence, un diviseur de fréquence programmable (15), un comparateur de phase (16), dont l'entrée de référence reçoit un signal de référence (fr) possédant une fréquence fixe, un intégrateur numérique (10), dont l'entrée d'incrémentation/décrémentation (10b) est reliée à la sortie du comparateur de phase (16), et enfin un second convertisseur numérique/ analogique (9), dont la sortie est raccordée à l'entrée de commande de l'oscillateur VCO (14).

3. Circuit de commande numérique (1) selon la revendication 2, caractérisé en ce que, lors du changement de la tension de réglage d'accord de syntoniseur (vt) dans le fonctionnement à cycle de recherche, le pré-positionnement de l'intégrateur numérique (10) est interrompu et que la valeur d'intégration (i) est modifiée uniquement par l'intermédiaire de pas fixes d'incrémentation, qui sont envoyés par l'intermédiaire de l'entrée d'incrémentation/de décrémentation (10b).

4. Circuit de commande numérique (1) selon l'une des revendications 1 à 3, caractérisé en ce qu'il contient une multiplicité de dispositifs (2) pour produire différentes tensions de réglage d'accord de syntoniseur (vt), les différentes données de réglage d'accord et les valeurs associées de données de prépositionnement (id) pour le fonctionnement de diodes non appariées de syntoniseur sont mémorisées à une adresse commune.

5. Circuit de commande numérique (1) selon l'une des revendications 1 à 4, caractérisé par les caractéristiques suivantes :
- le circuit de commande numérique (1) sert à réaliser la commutation des canaux de récepteurs de télévision dans le cas d'une réception multicanaux et d'une reproduction simultanée à images multiples ; et
- la commutation cyclique des canaux de réception est commandée par le dispositif d'exécution et de commande temporelle (7), les données nécessaires, telles que les numéros des canaux, une séquence, une durée de séjour ou une durée de cycle, étant introduites par l'intermédiaire du dispositif (8) d'entrée de données.

6. Circuit de commande numérique (1) selon l'une des revendications 2 à 5, caractérisé par les caractéristiques suivantes :
- le dispositif d'exécution de commande temporelle (7) contient un microprocesseur (29), qui peut être programmé et commandé par l'intermédiaire du dispositif (8) d'entrée de données et l'intégrateur numérique (10) et la première et la seconde lignes de transmission de données (11, 12) sont réalisées selon une technique logicielle.

7. Circuit de commande numérique (1) selon l'une des revendications 1 à 6, caractérisé en ce que l'additionneur (21) et le modulateur (23) de densité d'impulsions sont réalisés selon une technique logicielle.

8. Circuit de commande numérique (1) selon l'une des revendications 1 à 7, caractérisé en ce que le modulateur (23) de densité d'impulsions est constitué par un compteur à (m-n) chiffres, avec sortie de dépassement de capacité, dont l'entrée de données à (m-n) chiffres est alimentée par la partie de données de poids faible (il) et dont le signal de dépassement de capacité est envoyé en tant que signal modulé en densité d'impulsions, également désigné sous le terme de signal PDM (p2), à la position de poids le plus faible (LSB) de la seconde entrée de données (21b) de l'additionneur (21).

9. Circuit de commande numérique (1) selon la revendication 1 dans le cas du traitement ultérieur de la partie de données (ih) à n chiffres de poids supérieur, de la valeur d'intégration (i) ;
caractérisé par les caractéristiques suivantes :
- la partie de données à n chiffres de poids supérieur (ih) de la valeur d'intégration (i) est envoyée à l'entrée de données d'un convertisseur numérique/analogique statique à n chiffres (24a), qui contient, en tant qu'unités fonctionnelles, un convertisseur numérique/analogique proprement dit à n chiffres (24b) et un étage LSB séparé (24c) ;
- la partie restante de données (il) possédant (m-n) chiffres de poids faible de la valeur d'intégration (i) est envoyée à l'entrée de données d'un modulateur (23) de densité d'impulsions, qui est activée par une cadence constante (c1) du système ;
- le signal de sortie (p2) du modulateur (23) de densité d'impulsions est envoyé à l'étage LSB séparé (24c) ; et
- la sortie du convertisseur numérique/analogique proprement dit à n chiffres (24b) et la sortie de l'étage LSB séparé (24c) sont connectées à une entrée respective dans l'additionneur analogique (28), dont le signal de sortie est une tension de réglage d'accord non lissée de syntoniseur (vt′), qui est lissée au moyen d'un filtre passe-bas analogique possédant une faible constante de temps, le filtre de lissage (25), et forme la tension de réglage d'accord de syntoniseur (vt) possédant une résolution de 2^{m}-1.

10. Circuit de commande numérique (1) selon l'une des revendications 1 à 9, caractérisé en ce que plusieurs premiers convertisseurs numérique/analogique (3, 4, 5) servent à produire plusieurs tensions de réglage de fonctionnement (s1, s2, s3).
